# EUROPEAN PATENT APPLICATION

(11) **EP 1 715 644 A1**
(43) Date of publication of application: **25.10.2006**
(21) Application number: 05719102.5
(22) Date of filing: 14.02.2005
(51) Int. Cl.: H04L 27/22, H03L 7/08, H03L 7/087

(54) **PLL CIRCUIT, DEMODULATOR CIRCUIT, IC CARD, AND IC CARD PROCESSING APPARATUS**

(30) Priority: 12.02.2004 JP 2004035653
(71) Applicant: SONY CORPORATION, Tokyo 141-0001 (JP)
(72) Inventor: ARISAWA, Shigeru, c/o Sony Corporation, Tokyo 141-0001 (JP); ZHANG, Cheng, c/o Sony Corporation, Tokyo 141-0001 (JP)
(74) Representative: Thévenet, Jean-Bruno
(86) International application number: PCT/JP2005/002161
(87) International publication number: WO 2005/079032

(57) **Abstract**

The present invention is directed to a demodulating circuit adapted for reproducing, from an input signal which has been caused to undergo transmission through a desired transmission system, data sequential caused to undergo transmission through the input signal, which is adapted to perform phase comparison, by Exclusive-OR (EX-OR) circuits (254Q), (254I), between a first oscillating output signal generated by an oscillator (252) and a variable frequency divider (253) and a second oscillating output signal different from the first oscillating output signal by 90 degrees [π/2] in phase to judge control direction by a control direction judgment circuit (257) on the basis of polarities of the phase comparison results to integrate the control direction judgment results by one period of the input signal by an integrating circuit (258) to perform correction processing having a predetermined controlled variable in the case where phase difference is [± π/2] on the basis of the phase comparison result by a correction circuit (259) with respect to the integrated result to control the operation of the variable frequency divider (253) by the correction-processed control signal outputted once per each period.

## Description

### Technical Field

The present invention relates to a PLL circuit, a demodulating circuit, an IC card and an IC card processing apparatus, and is applied more particularly to an IC card adapted for performing input/output of various data in a non-contact manner, and an IC card processing apparatus adapted for performing data communication to and from such an IC card.

This Application claims priority of Japanese Patent Application No. 2004-035659, filed on February 12, 2004, the entirety of which is incorporated by reference herein.

### Background Art

Hitherto, IC card systems using IC card are used. The IC card systems of this kind are applied to examination of a ticket system of the traffic facilities and/or room entering/withdrawal management system, etc. Such IC card system comprises an IC card processing apparatus (processor) including an IC card that user carries, and a reader/writer for performing transmission/reception of various data to and from such IC card. In such IC card system, transmission/reception of various data is performed in a non-contact manner between the IC card and the reader/writer.

The reader/writer used in the IC card system of this kind serves to modulate a carrier wave of a predetermined frequency by a desired data sequential to generate a transmit signal to send out the transmit signal to the IC card. Moreover, the IC card serves to receive the transmit signal through an antenna to demodulate, from the transmit signal, the data which has been sent from the reader/writer. Further, the IC card serves to modulate, by a predetermined carrier wave, data such as personal information, etc. held therewithin in accordance with the received data to send out the modulated data thus obtained to the reader/writer.

The reader/writer is caused to be of the configuration to receive data which has been sent from the IC card to open or close the door or gate of ticket examination machine, or to permit entering/withdrawal of the room by the received data.

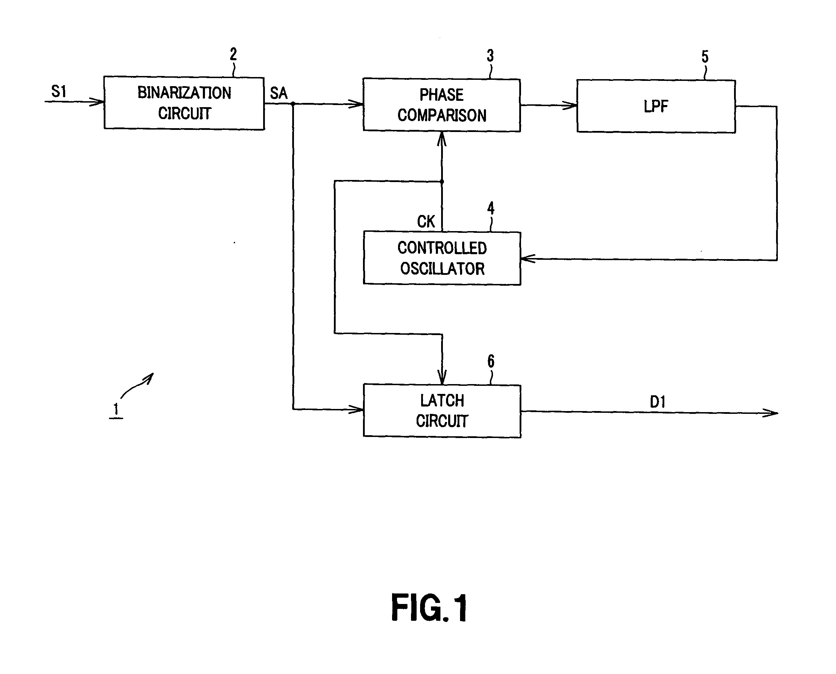

Such IC card system serves to receive, by using demodulator 1 as shown in FIG. 1, data which has been sent from the reader/writer, or to receive data which has been transmitted from the IC card. The demodulator 1 inputs a PSK modulating (modulation) signal S1 demodulated from antenna input to a binarization circuit 2 of the limiter circuit configuration. The PSK modulating signal S1 which has been inputted to the binarization circuit 2 is binarized. A phase comparison circuit 3 is comprised of Exclusive-OR circuit, etc. for performing phase comparison between a binarized signal SA outputted from the binarization circuit 2 and clock CK outputted from a controlled oscillating circuit (oscillator) 4, and serving to output phase comparison result to a Low Pass Filter (LPF) 5 irrespective of phase of the binarized signal SA. The low-pass filter 5 band-limits the phase comparison result to generate a control signal for the controlled oscillating circuit 4. The controlled oscillating circuit 4 allows oscillating frequency to be variable in accordance with the control signal.

Thus, the demodulator 1 constitutes a PLL circuit, and serves to generate clock CK which is phase-synchronized with the binarized signal SA to reproduce clock CK from PSK modulating signal. A latch circuit 6 sequentially latches binarized signals by the clock CK to thereby output data sequential D1 in which the PSK modulating signal S1 has been demodulated.

Meanwhile, in the IC card system, antenna input changes to much degree depending upon distance between the IC card and the reader/writer. Followed by this, waveform of the PSK modulating signal S1 is considerably deteriorated, and the S/N ratio is also greatly deteriorated.

As a result, in the conventional demodulator, duty ratio is changed in the binarized signal obtained by binarizing PSK modulating signal S1. Thus, it becomes difficult to precisely reproduce clock of the PSK modulating signal S1 from the binarized signal SA. When it becomes difficult to precisely reproduce clock in this way, it also becomes difficult to precisely reproduce data accordingly.

As one method of solving this problem, the applicant of the present invention has proposed, in the Japanese Patent Application Laid Open No. 1999-274919 publication, such a demodulating circuit to demodulate PSK modulating signal by costas loop.

### Disclosure of the Invention

### Problems to be solved by the invention

In the case of receiving PSK modulated or Manchester encoded digital data in a manner as described above, there is necessity of performing extraction of sampling clock. In the PLL circuit such as costas loop, etc., phase comparison between an output signal of an internal oscillator mounted therewithin and digital data to be received is performed to perform control of oscillating frequency and phase of the internal oscillator by the result thereof to thereby perform extraction of sampling clock.

However, phase difference such that phase error cannot be detected exists in principle depending upon duty or phase state of data. Therefore, when phase state results in such phase difference, errorneous lock state would take place.

In view of the problems as described above, an object of the present invention is to provide a PLL circuit, a demodulating circuit, and an IC card and an IC card processing apparatus which use these circuits which are adapted for detecting erroneous lock state to avoid that state to thereby have ability to securely extract sampling clock.

The present invention is directed to a PLL circuit adapted for reproducing, from an input signal which has been caused to undergo transmission through a desired transmission system, clock of the input signal, the PLL circuit comprising: a binarization circuit for binarizing the input signal to generate a binarized signal; a signal generating circuit for allowing frequency to be variable by a control signal to output a first oscillating output signal and a second oscillating output signal different from the first oscillating output signal by 90 degrees [π/2] in phase; a first phase comparison circuit for performing phase comparison between the first oscillating output signal and the binarized signal to output a first phase comparison result; a second phase comparison circuit for performing phase comparison between the second oscillating output signal and the binarized signal to output a second phase comparison result; a control direction judgment circuit for judging control direction by the control signal on the basis of polarities of the first and second phase comparison results to output control direction judgment result; an integrating circuit for integrating the control direction judgment results to output an integrated result; and a correction circuit for discriminating whether or not the integrated result is zero to detect, from the discrimination result and an output of the first or second phase comparison circuit, that phase difference is [±π/2] to output a control signal in which correction processing has been performed on the basis of the detection result thus obtained, whereby to control the operation of the signal generating circuit by the correction-processed control signal.

Moreover, the present invention is directed to a demodulating circuit adapted for reproducing, from an input signal which has been caused to undergo transmission through a desired transmission system, data sequential caused to undergo transmission through the input signal, the demodulating circuit comprising: a binarization circuit for binarizing the input signal to generate a binarized signal; a signal generating circuit for allowing frequency to be variable by a control signal to output a first oscillating output signal and a second oscillating output signal different from the first oscillating output signal by 90 degrees [π/2] in phase; a first phase comparison circuit for performing phase comparison between the first oscillating output signal and the binarized signal to output a first phase comparison result; a second phase comparison circuit for performing phase comparison between the second oscillating output signal and the binarized signal to output a second phase comparison result; a control direction judgment circuit for judging control direction by the control signal on the basis of the polarities of the first and second phase comparison results to output control direction judgment result; an integrating circuit for integrating the control direction judgment results by one period of the input signal to output an integrated result; and a correction circuit for discriminating whether or not the integrated result is zero to detect, from the discrimination result and an output of the first or second phase comparison circuit, that phase difference is [±π/2] to output a control signal in which correction processing has been performed on the basis of the detection result thus obtained, whereby to control the operation of the signal generating circuit by the correction-processed control signal to output the data sequential by the first or second phase comparison result.

The present invention is directed to an IC card adapted for demodulating data sequential, by a demodulating circuit, from a transmit signal which has been received through an antenna to process the demodulated data sequential thus obtained, the demodulating circuit comprising: a binarization circuit for binarizing the transmit signal to generate a binarized signal; a signal generating circuit for allowing frequency to be variable by a control signal to output a first oscillating output signal and a second oscillating output signal different from the first oscillating output signal by 90 degrees [π/2] in phase; a first phase comparison circuit for performing phase comparison between the first oscillating output signal and the binarized signal to output a first phase comparison result; a second phase comparison circuit for performing phase comparison between the second oscillating output signal and the binarized signal to output a second phase comparison result; a control direction judgment circuit for judging control direction by the control signal on the basis of polarities of the first and second phase comparison results to output control direction judgment result; an integrating circuit for integrating the control direction judgment results by one period of the input signal to output an integrated result; and a correction circuit for discriminating whether or not the integrated result is zero to detect, from the discrimination result and an output of the first or second phase comparison circuit, that phase different is [±π/2] to output a control signal in which correction processing has been performed on the basis of the detection result thus obtained, whereby to control the operation of the signal generating circuit by the correction-processed control signal to output the data sequential by the first or second phase comparison result.

Further, the present invention is directed to an IC card processing apparatus adapted for demodulating, from a response signal which has been received through an antenna, data sequential which has been sent out from an IC card by using a demodulating circuit to process the demodulated data sequential thus obtained, the demodulating circuit comprising: a binarization circuit for binarizing the response signal to generate a binarized signal; a signal generating circuit for allowing frequency to be variable by a control signal to output a first oscillating output signal and a second oscillating output signal different from the first oscillating output signal by 90 degrees [π/2] in phase; a first phase comparison circuit for performing phase comparison between the first oscillating output signal and the binarized signal to output a first phase comparison result; a second phase comparison circuit for performing phase comparison between the second oscillating output signal and the binarized signal to output a second phase comparison result: a control direction judgment circuit for judging control direction by the control signal on the basis of polarities of the first and second phase comparison results to output control direction judgment result; an integrating circuit for integrating the control direction judgment results by one period of the input signal to output an integrated result; and a correction circuit for discriminating whether or not the integrated result is zero to detect, from the discrimination result and an output of the first or second phase comparison circuit, that phase difference is [±π/2] to output a control signal in which correction processing has been performed on the basis of the detection result thus obtained, whereby to control the operation of the signal generating circuit by the correction-processed control signal to output the data sequential by the first or second phase comparison result.

Since the present invention is adapted to integrate, by one period of an input signal, control direction judgment results in which control direction by control signal has been judged on the basis of polarities of first and second phase comparison results to discriminate whether or not the integrated result is zero to detect, from the discrimination result and output of the first or second phase comparison circuit, that phase difference is [±π/2] to perform correction processing on the basis of the detection result thus obtained to control oscillating frequency by the correction-processed control signal, it is possible to avoid erroneous lock state to securely extract sampling clock. Thus, it is possible to securely process an input signal by simple configuration and in the case where the input signal is deteriorated.

Still further objects of the present invention and practical merits obtained by the present invention will become more apparent from the embodiments which will be explained below with reference to the attached drawings.

### Brief Description of the Drawings

FIG. 1 is a block circuit diagram showing a conventional demodulator.
FIG. 2 is a block circuit diagram showing an embodiment of an IC card system to which the present invention has been applied.
FIG. 3 is a block circuit diagram showing modulation/demodulation circuits of IC card and reader/writer in the IC card system.
FIG. 4 is a characteristic curve diagram showing frequency spectrums of transmit signal and response signal in the IC card system.
FIG. 5 is a block circuit diagram showing a demodulator applied to the modulation/demodulation circuits at IC card and reader/writer.
FIGS 6A to 6H are signal waveform diagrams used for explanation of the operation of the demodulator.
FIGS. 7A to 7D are characteristic curve diagrams used for explanation of the operation of the demodulator.
FIG. 8 is a table used for explanation of control direction judgment circuit of the demodulator.

### Best Mode for Carrying Out the Invention

Embodiments of the present invention will be described in detail with reference to the attached drawings.

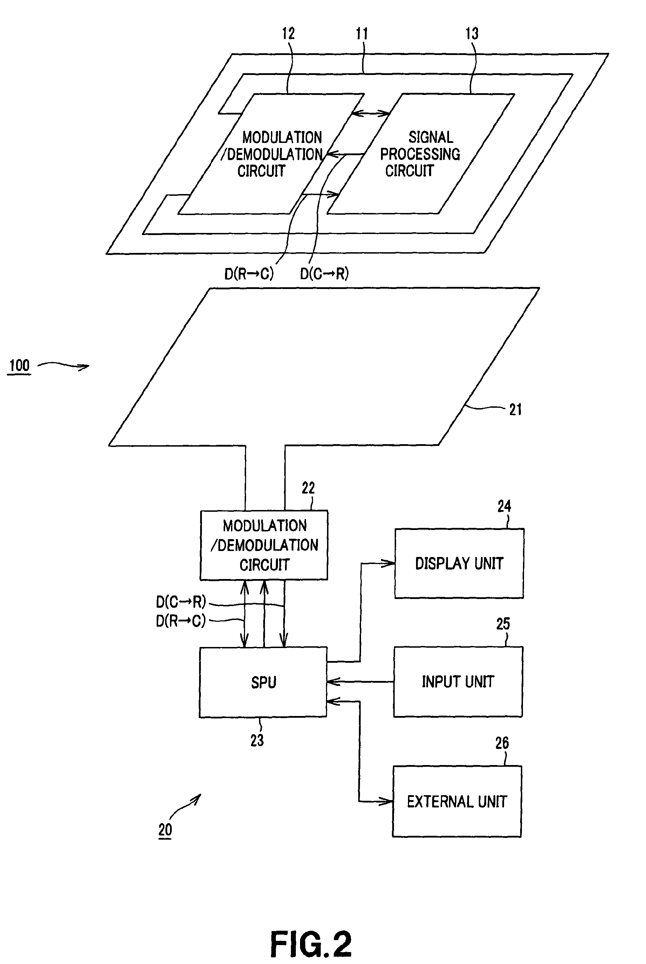

The present invention is applied to an IC card system 100 having a configuration as shown in FIG. 2. The IC card system 100 of this embodiment is applied to, e.g., ticket examination system of the traffic facilities, and serves to perform data communication between an IC card 10 and a reader/writer 20. While explanation will be given in the following explanation by taking example of an IC card having card shape as data communication apparatus, it is a matter of course that IC chip having the so-called IC card function to perform certification/settlement of accounts, etc. may be mounted at information terminal equipment such as mobile telephone, etc.

The IC card 10 is formed so as to have card shape in the state where a board on which integrated circuits are mounted and protective sheet are laminated. A loop antenna 11 is formed by wiring pattern on board 10a, and a modulation/demodulation circuit 12 and a signal processing circuit 13 are formed by integrated circuits mounted on the board 10a.

The loop antenna 11 serves to couple with a loop antenna 21 of the reader/writer 20 to receive a transmit signal which has been sent out from the loop antenna 21, and to radiate a response signal generated at the modulation/demodulation circuit 12.

The modulation/demodulation circuit 12 generates, from the transmit signal which has been received at the loop antenna 11, power and clock, etc. required for the operation of the IC card 10. Further, the modulation/demodulation circuit 12 becomes operative by the power and the clock to demodulate data sequential sent out from the reader/writer 20 from the transmit signal (hereinafter referred to as transmit data sequential) D(R→C) to output the demodulated data sequential thus obtained to a signal processing circuit 13. Moreover, transmitting (sending) operation is hastened by the transmit data sequential D(R→C) to generate a response signal from data sequential inputted from the signal processing circuit 13 (hereinafter referred to as response data sequential) D(C→R) to drive the loop antenna 11 by the response signal to radiate the response signal.

The signal processing circuit 13 becomes operative by power and clock which have been generated at the modulation/demodulation circuit 12 to analyze transmit data sequential D(R→C) to output response data sequential D(C→R) to a modulation/demodulation circuit 15 as occasion demands.

At the reader/writer 20, a modulation/demodulation circuit 22 generates a transmit signal from the transmit data sequential D(R→C) inputted from a SPU (Signal Process Unit) 23 to drive a loop antenna 21 by the transmit signal. In addition, the modulation/demodulation circuit 22 performs signal processing of the response signal which has been received at the loop antenna 21 to demodulate response data sequential D(C→R) which has been sent out from the IC card 10 to output the response data sequential D(C→R) to the SPU 23.

The SPU 23 is comprised of arithmetic processing unit for executing relatively simple processing procedure, and serves to send out transmit data sequential D(R→C) to be transmitted to the IC card 10 to the modulation/demodulation circuit 22, and processes response data sequential D(C→R) inputted from the modulation/demodulation circuit 22. In this processing, the SPU 23 displays processing process and processing result on a display unit 24 as occasion demands. In addition, the SPU 23 switches the operation by command from the input unit 25 to input/output data such as processing procedure, etc. to and from an external unit 26 as occasion demands.

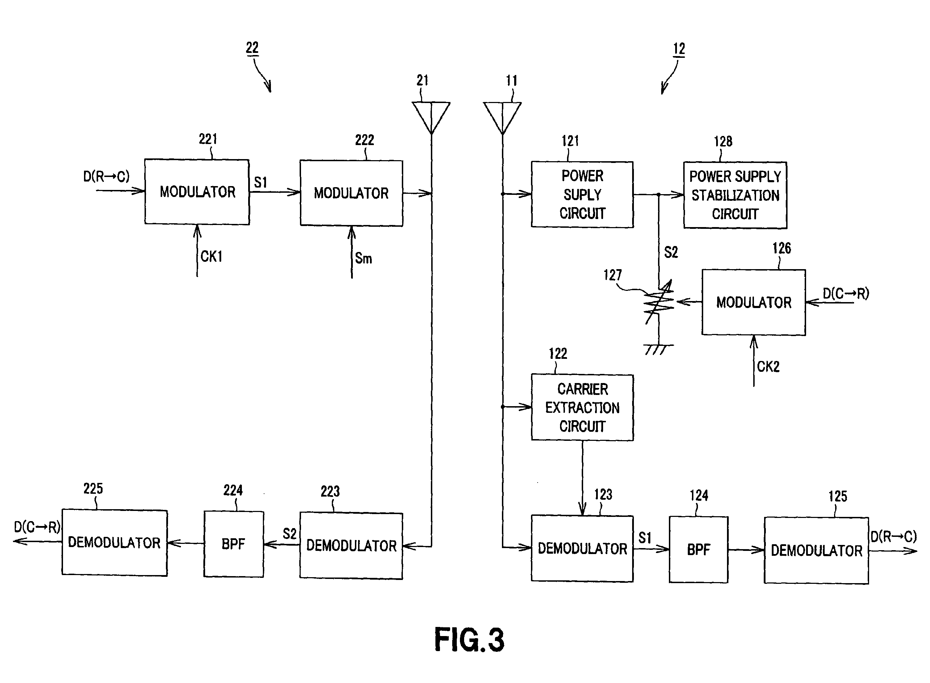

FIG. 3 is a block circuit diagram showing the modulation/demodulation circuit 12 of the IC card 10 and the modulation/demodulation circuit 22 of the reader/writer 20.

At the modulation/demodulation circuit 22 of the reader/writer 20, a modulator 221 performs PSK modulation of transmit data sequential D(R→C) inputted from the SPU 23 by clock CK1 of a predetermined frequency F1 to output a PSK modulating (modulation) signal S1. In this case, transmit data rate and frequency of clock CK1 are in correspondence with each other. In the case of a specific phase relationship, Manchester code is provided. A modulator 222 performs ASK modulation of the PSK modulating (modulation) signal S1 outputted from the modulator 221 by main carrier wave Sm of a predetermined frequency Fm to drive the loop antenna 21.

Thus, the reader/writer 20 serves to modulate transmit data sequential D(R→C) in two stages to generate a transmit signal to send out the transmit signal thus generated from the loop antenna 21.

At the modulation/demodulation circuit 12 of the IC card 10 side, a power supply circuit 121 receives the transmit signal induced at the loop antenna 11 to rectify the transmit signal to generate d.c. power. The power supply circuit 121 delivers the d.c. power to respective circuit blocks of the IC card 10. Thus, the modulation/demodulation circuit 12 and the signal processing circuit 13 are operated by power of the transmit signal.

A carrier extractor 122 receives the transmit signal from the loop antenna 11 to extract main carrier wave component from the transmit signal. Further, this main carrier wave component is caused to be operating clock to provide an output to the demodulator 123. Further, the carrier extractor 122 generates various reference clocks with the operating clock being as reference to output the reference clocks to the signal processing outputs 13, etc.

The demodulator 123 receives the transmit signal from the loop antenna 11 to process the transmit signal thus received by using operating clock outputted from the carrier extractor 122 to thereby demodulate PSK modulating signal S1 of the modulator 221 which is superimposed on the transmit signal.

The band-pass filter 124 band-limits the PSK modulating signal S1 outputted from the demodulator 123 to thereby selectively output a signal component corresponding to output signal S1 of the modulator 221.

The demodulator 125 demodulates the transmit data sequential D(R→C) from an output signal of the band-pass filter 124 to output the transmit data sequential D(R→C) to the signal processing circuit 13. Thus, the IC card 10 is adapted to have ability to receive the transmit data sequential D(R→C) which has been sent out from the reader/writer 20.

The modulator 126 receives response data sequential D(C→R) to be sent out from the signal processing circuit 13 to the reader/writer 20 to perform PSK modulation of the response data sequential D(C→R) by clock CK2 of a predetermined frequency F2 to output the PSK modulated signal S2. In this case, rate of the response data sequential and frequency of the clock CK2 are in correspondence with each other. In the case of specific phase relationship, Manchester code is provided.

A load circuit 127 is connected to a line for power outputted from the power supply circuit 121 to change resistance value in accordance with an output signal S2 of the modulator 126. As a result, the load circuit 127 changes load of the power supply circuit 121 in accordance with output signal S2 to change input impedance of the power supply circuit 121 when viewed from the loop antenna 11 in accordance with output signal S2. Thus, the load circuit 127 changes, in accordance with output signal S2 of the modulator 126, power of a transmit signal which is induced at the loop antenna 11 and is re-radiated from the loop antenna 11.

The power which is re-radiated from the loop antenna 11 in this way is power mainly based on main carrier wave Sm. In the periphery of the loop antenna 11, there is formed electro-magnetic field by main carrie wave Sm of which intensity changes in accordance with output signal S2 of the modulator 126. Thus, the modulation/demodulation circuit 12 equivalently performs ASK modulation of output signal S1 of the modulator 126 by main carrier wave Sm to generate a response signal for carrying response data sequential D(C→R) with respect to the reader/writer 20 to radiate the response signal from the loop antenna 11.

Thus, the load circuit 127 constitutes a modulation circuit for modulating, in two stages, the data sequential D(C→R) along with the power supply circuit 121. A power supply stabilization circuit 128 serves to stabilize power supply voltage changing by change of load in this way to output the power supply voltage thus stabilized.

At the modulation/demodulation circuit 22 of the reader/writer 20 side, a demodulator 223 receives a response signal which is generated in this way, and is induced at the loop antenna 21 to demodulate an output signal S2 of the modulator 126 which has been superimposed on the response signal.

A band-pass filter 224 band-limits an output signal of the demodulator 223 to thereby selectively output a signal component corresponding to output signal S2 of the modulator 126.

A demodulator 225 demodulates response data sequential D(C→R) from an output signal of the band-pass filter 224 to output the data sequential D(C→R) to the SPU 23. Thus, the reader/writer 20 is adapted to have ability to receive the response data sequential D(C→R) which has been sent out from the IC card 10.

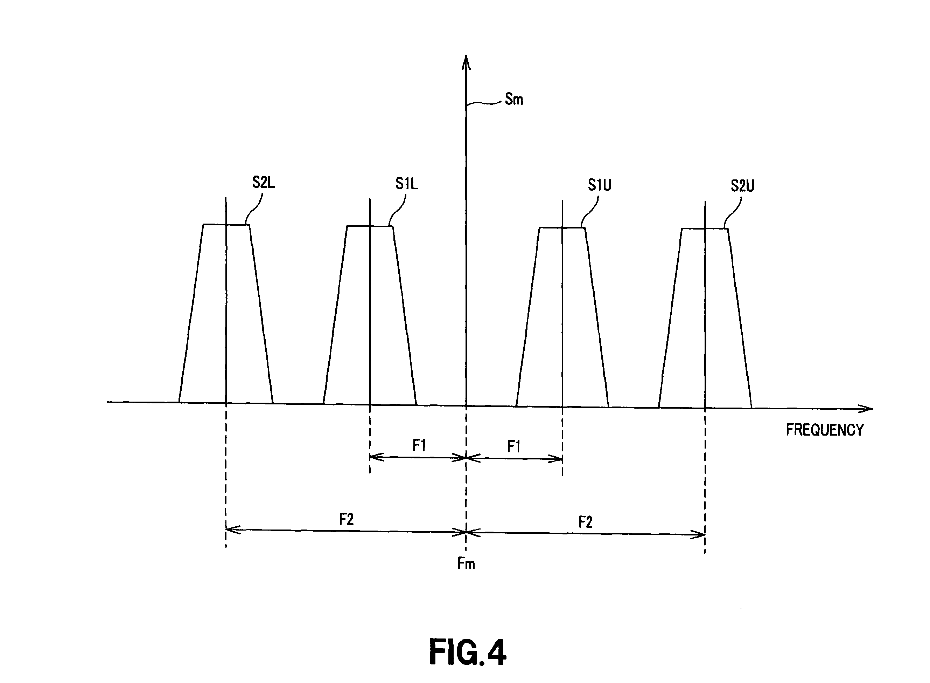

In the IC card 10 and the reader/writer 20 which are adapted for performing transmission/reception of data sequential in this way, frequencies F1 and F2 of the clocks CK1 and CK2 are set by frequencies different by a predetermined frequency. Moreover, as shown in FIG. 4, the frequencies F1 and F2 are set to frequencies sufficiently apart (in terms of time) from each other so that sidebands S1U, S1L and S2U, S2L do not overlap when PSK modulating signal S1 outputted from the modulator 221 of reader/writer 20 side and PSK modulating signal S2 outputted from the modulator 126 of the IC card 10 side are viewed on the frequency axis, and so that signal components of PSK modulating signals S1 and S2 can be respectively extracted by band-pass filters 124, 224 of the simple configuration when these PSK modulating signals S1 and S2 are superimposed.

Thus, the IC card 10 and the reader/writer 20 are adapted to have ability to bidirectionally perform data exchange at the same time.

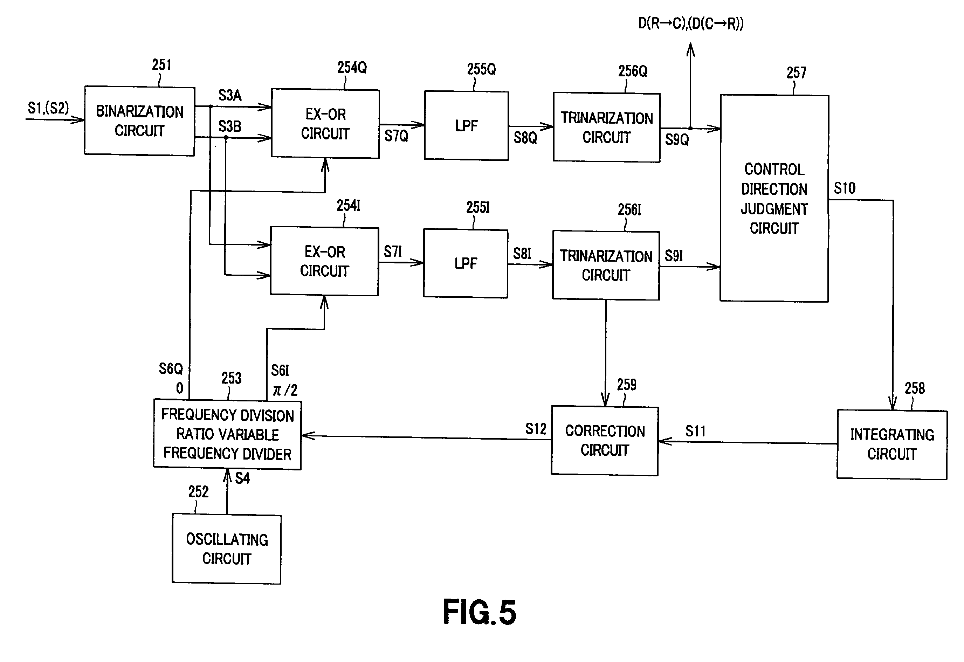

FIG. 5 is a block circuit diagram showing demodulators 125, 225 applied to modulation/demodulation circuits 12, 22 at the IC card 10 and the reader/writer 20. In the IC card system 100, since these demodulators 125, 225 are caused to be of the same configuration except that signals to be processed are different, only the demodulator 12 of the IC card 10 side will be explained, indication is made such that reference numerals corresponding to different portions in FIG. 2 are attached with respect to the demodulator 225 of the reader/writer 20 side, and their repetitive explanation will be omitted. In the IC card system 100, PSK modulating signals S1, S2 are processed at the demodulators 125, 225 to demodulate data sequentials D(R → C), D(C →R).

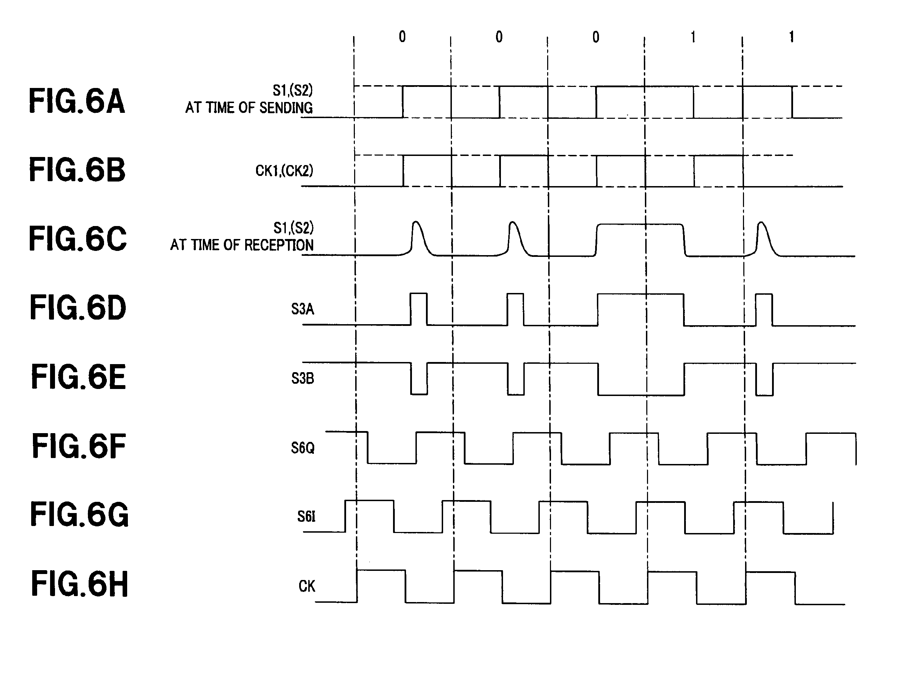

It is to be noted that Manchester coding is bit coding in which phase is inverted at one period of clock in accordance with logical level of data subject to transmission as shown in FIGS. 6A and 6B. Thus, in the PSK modulating signals S1, S2, there takes place the case where transmission of edge information of clocks CK1, CK2 may not be performed in accordance with the logical level of data subject to transmission (sending).

In the IC card system 100, when distance between the IC card 10 and the reader/writer 20 becomes apart from each other, SN ratios of demodulated PSK modulating signals S1, S2 are deteriorated and waveform distortion takes place as shown in FIG. 6C.

A binarization circuit 251 is comprised of a binarization circuit of the limiter circuit configuration, and serves to binarize a PSK modulating signal S1 inputted from the band-pass filter 124 to output a binarized signal S3A in which one period consists of 8 (eight) samples as shown in FIG. 6D and a binarized signal S3B as shown in FIG. 6E in which the polarity of the binarized signal 3A is inverted. In this case, in the binarized signals S3A, S3B, reproduction is performed in the state where duty ratio is changed from 50 [%] to such a degree that waveforms of PSK modulating signals S1, S2 are distorted.

An oscillator (oscillating circuit) 252 oscillates frequency (13.56 MHz) which is N times (e.g., N = 64) greater than the frame rate with respect to the clock CK1 of PSK modulating signal S1 having frame rate, e.g., 211 Kps to output an oscillating output signal S4 by a rectangular wave signal.

A variable frequency divider 253 frequency-divides an oscillating output signal S4 of the oscillator 252 into 1/N to output a first oscillating output signal S6Q as shown in FIG. 6F having frequency substantially equal to that of the PSK modulating signal S1, and a second oscillating output signal S6I as shown in FIG. 6G different from the first oscillating output signal S6Q by 90 degrees in phase.

An Exclusive-OR (EX-OR) circuit 254Q outputs phase comparison result S7Q between the first oscillating output signal S6Q and the binarized signal 3A as exclusive logical sum output of the first oscillating output signal S6Q and the binarized signal S3A. An Exclusive-OR (EX-OR) circuit 254I outputs phase comparison result S7I between the second oscillating output signal S6I and the binarized signal S3B as exclusive logical sum output of the second oscillating output signal S6I and the binarized signal S3B.

A Low-Pass Filter (LPF) 255Q obtains, as quinary value output, movement average every half-period of 4 (four) samples with respect to phase comparison result S7Q obtained by the EX-OR circuit 254Q to output the movement average value S8Q thus obtained. A Low-Pass Filter (LPF) 2551 obtains, as quinary value output, movement average every half-period of 4 (four) samples with respect to phase comparison result S7I obtained by the EX-OR circuit 254I to output the movement average value S8I.

A trinarization circuit 256Q changes movement average value S8Q of quinary value outputted from the LPF 255Q into ternary value to output the trinary value thus obtained to a control direction judgment circuit 257. A trinarization circuit 2561 changes movement average value S8I of quinary value outputted from the LPF 255I into ternary value to output the ternary value thus obtained to a control direction judgment circuit 257 and a correction circuit 259.

The control direction judgment circuit 257 determines variable (adjustable) direction of frequency division ratio at the variable frequency divider 52 on the basis of trinarized signals S9Q, S9I obtained by the trinarization circuits 256Q, 256I to output a control signal S10 in accordance with the variable (adjustable) direction.

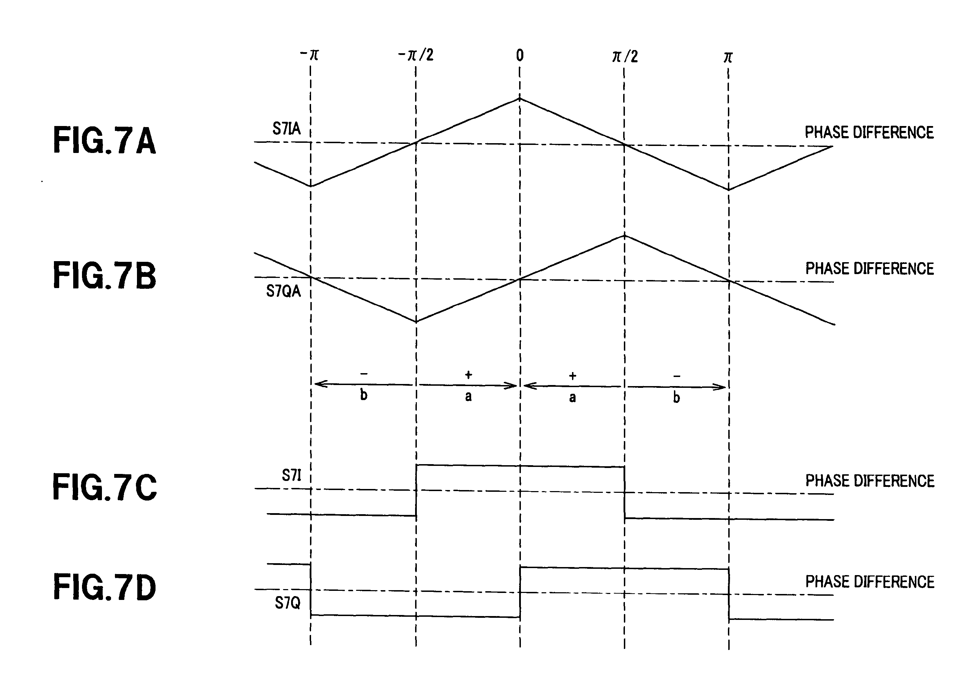

Here, as shown in FIGS. 7A to 7D, phase comparison results by exclusive logical sum with respect to clock CK1 are indicated by analog quantities S7IA, S7QA in accordance with comparison between phase comparison result S7Q between first oscillating output signal S6Q and binarized signal S3A and phase comparison result S7I between second oscillating output signal S6I and binarized signal S3B. As a result, when phase coincides with respect to clock CK1, i.e., phase difference is 0 (zero) and π/2, large values are respectively obtained as phase comparison results S7I, S7Q. At this time, in the phase comparison results different by 90 degrees in phase, phase comparison result of value 0 (zero) can be obtained. Further, these values change by change of phase difference so as to have triangular wave shape (see FIGS. 7A and 7B).

This relationship is indicated by signs of phase comparison results S7I, S7Q as shown in FIGS. 7C and 7D. In the second phase comparison S7I, value rises up to positive value within the range from - 90 degrees [- π/2] to 90 degrees [+ π/2], and value falls down to negative value within the range from -90 degrees [- π/2] to - 180 degrees [-π] and the range from 90 degrees [+ π/2] to 180 degrees [+ π]. Moreover, in the first phase comparison result S7Q different therefrom by 90 degrees [π/2] in phase, value rises up to positive value within the range from 0 (zero) degrees [0] to 90 degrees [+ π/2], and value falls down to negative value within the range from 0 (zero) degrees [0] to -180 degrees [- π].

Thus, it is understood that it is possible to roughly detect phase shift with respect to binarized signal S3A by signs of the phase comparison results S7I, S7Q.

On the contrary, in the Manchester code serving as generating reference of binarized signal 3A, phases of 0 (zero) degrees [0] and 180 degrees [π] are formed with respect to clock CK in accordance with logical level of data. In this case, in the phase comparison results S7I, S7Q using binarized signal 3A, portions which are phase-synchronized with respect to clock CK1 are switched at phase difference 0 (zero) degrees [0] and phase difference 180 degrees [π] in accordance with data caused to undergo transmission by the PSK modulating signal S1.

Thus, within the range where phase difference detected by phase comparison result S7I is -90 degrees [-π/2] to 90 degrees [+π/2], as indicated by arrow a in FIG. 7, control is performed such that phase difference of the phase comparison result S7Q becomes equal to 0 degrees [0], thereby making it possible to synchronize oscillating output signal S6I serving as generating reference of phase comparison result S7I with clock CK.

Moreover, within the range where phase difference detected by phase comparison result S71 is -180 degrees [-π] to -90 degrees [-π/2], and 90 degrees [+π/2] to 180 degrees [+π], control is made as indicated by arrow b in FIG. 7 so that phase difference of the phase comparison result S7Q becomes equal to 180 degrees, thus making it possible to synchronize oscillating output signal S6I serving as generating reference of phase comparison result S71 with clock CK.

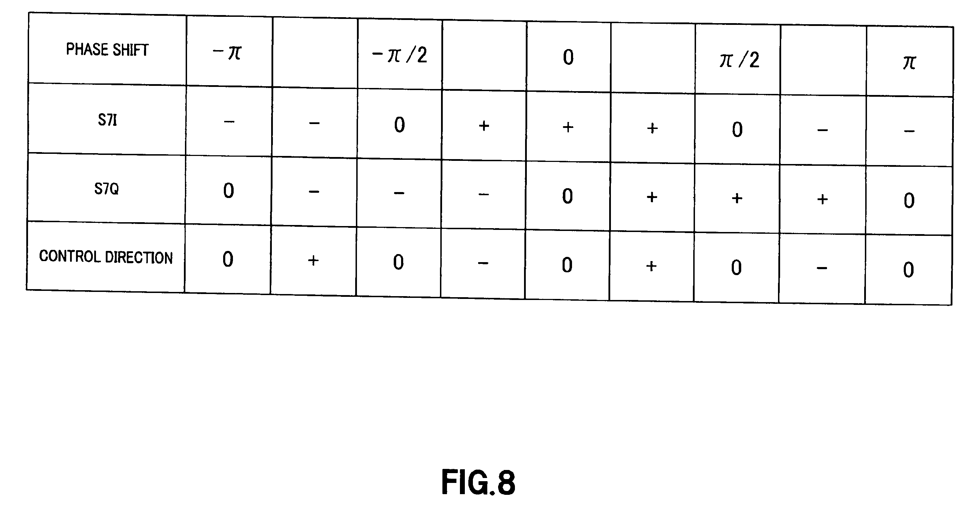

As shown in FIG. 8, in accordance with this relationship, the control direction judgment circuit 257 holds table in which signs of phase comparison results S7I, S7Q are caused to be address to determine control direction (lead [+], lag[-]) by the table to output control signal S10 in accordance with the control direction.

An integrating circuit 258 determines sum total S11 of 8 (eight) samples corresponding to one period with respect to control signal S10 obtained by the control direction judgment circuit 257.

A correction circuit 259 detects, on the basis of a trinarized signal S91 obtained by the trinarizaion circuit 256I, that phase difference in which phase error existing in principle cannot be detected is [±π/2] to output, to the variable frequency divider 52, once per each period, a correction-processed control signal S12.

In accordance with the demodulating circuit of the configuration shown in FIG. 5, there is employed an approach to determine control direction in accordance with polarities of first and second phase comparison results from the first and second phase comparison results by oscillating output signals different from each other by 90 degrees in phase to allow oscillating frequency to be variable, thereby making it possible to securely reproduce clock CK by a simple configuration, and even in the case where PSK modulating signals S1, S2 are deteriorated to demodulate the reproduced data thus obtained.

In addition, there is employed an approach to detect that corresponding phase difference is phase difference [±π/2] where there is the possibility that erroneous lock state may result to perform correction with respect to controlled variable by the correction circuit 259 to thereby have ability to securely reproduce clock CK without being brought into erroneous lock state to demodulate the reproduced data thus obtained.

Namely, in the embodiment of the present invention, as a configuration for outputting first and second phase comparison results by oscillating output signals different from each other in phase, there may be employed, e.g., a configuration to obtain, as an output, movement average with respect to phase comparison result of the phase comparison circuit to process the movement average value thus obtained to provide an output thereof. As a result, it is detected on the basis of such an output that corresponding phase difference is phase difference [±π/2] furthest apart from phase to be locked to make correction by a predetermined controlled variable to thereby have ability to securely reproduce clock CK without being brought into erroneous lock state to demodulate the reproduced data thus obtained.

It is to be noted that while the case where IC card is caused to become operative by power of a transmit signal has been described in the above-described embodiments, the present invention is not limited to such an implementation, but can be widely applied to the case where the IC card is caused to become operative by battery, etc.

Moreover, while the case where clock is generated from PSK modulating signal by Manchester code, and data is demodulated has been described in the above-described embodiments, the present invention is not limited to such an implementation, but can be widely applied to the case where clock is generated by various modulating signals and/or data is reproduced by using such a clock, such as, for example, the case where clock is generated by various PSK modulating signals and data is demodulated, and/or the case where clock is generated by ASK modulating signal, etc.

Further, while explanation has been given in the above-described embodiments that the present invention is applied to the IC card and the reader/writer comprised of IC card processing apparatus, the present invention is not limited to such implementation, but can be widely applied to PLL circuits and demodulating circuits of various data transmission apparatuses.

It is to be noted that while the present invention has been described in accordance with certain preferred embodiments thereof illustrated in the accompanying drawings and described in detail, it should be understood by those ordinarily skilled in the art that the invention is not limited to embodiments, but various modifications, alternative construction or equivalents can be implemented without departing from the scope and spirit of the present invention as set forth by appended claims.

## Claims

1. A PLL circuit adapted for reproducing, from an input signal which has been caused to undergo transmission through a desired transmission system, clock of the input signal,
the PLL circuit comprising:
a binarization circuit for bianarizing the input signal to generate a binarized signal;
a signal generating circuit for allowing frequency to be variable by a control signal to output a first oscillating output signal and a second oscillating signal different from the first oscillating output signal by 90 degrees [π/2] in phase;
a first phase comparison circuit for performing phase comparison between the first oscillating output signal and the binarized signal to output a first phase comparison result;
a second phase comparison circuit for performing phase comparison between the second oscillating output signal and the binarized signal to output a second phase comparison result,
a control direction judgment circuit for judging, on the basis of polarities of the first and second phase comparison results, control direction by the control signal to output control direction judgment result;
an integrating circuit for integrating the control direction judgment results to output an integrated result; and
a correction circuit for discriminating whether or not the integrated result is zero to detect, from the discrimination result and an output of the first or second phase comparison circuit, that the phase difference is [±π/2] to output a control signal in which correction processing has been performed on the basis of the detection result thus obtained,
whereby to control the operation of the signal generating circuit by the correction-processed control signal.

2. The PLL circuit as set forth in claim 1,
wherein the input signal consists of a PSK modulating signal.

3. The PLL circuit as set forth in claim 1,
wherein the input signal consists of a modulating signal by Manchester code.

4. A demodulating circuit adapted for reproducing, from an input signal which has been caused to undergo transmission through a desired transmission system, data sequential caused to undergo transmission through the input signal,
the demodulating circuit comprising:
a binarization circuit for binarizing the input signal to generate a binarized signal;
a signal generating circuit for allowing frequency to be variable by a control signal to output a first oscillating output signal and a second oscillating output signal different from the first oscillating output signal by 90 degrees [π/2] in phase;
a first phase comparison circuit for performing phase comparison between the first oscillating output signal and the binarized signal to output a first phase comparison result;
a second phase comparison circuit for performing phase comparison between the second oscillating signal and the binarized signal to output a second phase comparison result;
a control direction judgment circuit for judging control direction by the control signal on the basis of polarities of the first and second phase comparison results to output control direction judgment result;
an integrating circuit for integrating the control direction judgment results by one period of the input signal to output an integrated result; and
a correction circuit for discriminating whether or not the integrated result is zero to detect, from the discrimination result and an output of the first or second phase comparison circuit, that the phase difference is [±π/2] to output a control signal in which correction processing has been performed on the basis of the detection result thus obtained,
whereby to control the operation of the signal generating circuit by the correction-processed control signal to output the data sequential by the first or second phase comparison result.

5. The demodulating circuit as set forth in claim 4,
wherein the input signal consists of a PSK modulating signal.

6. The demodulating circuit as set forth in claim 5,
wherein the input signal consists of a modulating signal by Manchester code.

7. An IC card adapted for demodulating data sequential, by a demodulating circuit, from a transmit signal which has been received through an antenna to process the demodulated data sequential thus obtained,
the demodulating circuit comprising: a binarization circuit for binarizing the transmit signal to generate a binarized signal; a signal generating circuit for allowing frequency to be variable by a control signal to output a first oscillating output signal and a second oscillating output signal different from the first oscillating output signal by 90 degrees [π/2] in phase; a first phase comparison circuit for performing phase comparison between the first oscillating output signal and the binarized signal to output a first phase comparison result; a second phase comparison circuit for performing phase comparison between the second oscillating output signal and the binarized signal to output a second phase comparison result; a control direction judgment circuit for judging control direction by the control signal on the basis of polarities of the first and second phase comparison results to output control direction judgment result; an integrating circuit for integrating the control direction judgment results by one period of the input signal to output an integrated result; and a correction circuit for discriminating whether or not the integrated result is zero to detect, from the discrimination result and an output of the first or second phase comparison circuit that the phase difference is [± π/2] to output a control signal in which correction processing has been performed on the basis of the detection result thus obtained,
whereby to control the operation of the signal generating circuit by the correction-processed control signal to output the data sequential by the first or second phase comparison result.

8. The IC card as set forth in claim 7,
wherein the transmit signal consists of a PSK modulating signal.

9. The IC card as set forth in claim 7,
wherein the transmit signal consists of a modulating signal by Manchester code.

10. An IC card processing apparatus adapted for demodulating, from a response signal which has been received through an antenna, data sequential which has been sent out from an IC card by using a demodulating circuit to process the data sequential thus demodulated,
the demodulating circuit comprising: a binarization circuit for binarizing the response signal to generate a binarized signal; a signal generating circuit for allowing frequency to be variable by a control signal to output a first oscillating output signal and a second oscillating output signal different from the first first output signal by 90 degrees [π/2] in phase; a first phase comparison circuit for performing phase comparison between the first oscillating output signal and the binarized signal to output a first phase comparison result; a second phase comparison circuit for performing phase comparison between the second oscillating output signal and the binarized signal to output a second phase comparison result; a control direction judgment circuit for judging control direction by the control signal on the basis of polarities of the first and second phase comparison results to output control direction judgment result; an integrating circuit for integrating the control direction judgment results by one period of the input signal to output an integrated result; and a correction circuit for discriminating whether or not the integrated result is zero to detect, from the discrimination result and an output of the first or second phase comparison circuit, that the phase difference is [± π/2] to output a control signal in which correction processing has been performed on the basis of the detection result thus obtained,
whereby to control the operation of the signal generating circuit by the correction-processed control signal to output the data sequential by the first or second phase comparison result.

11. The IC card processing apparatus as set forth in claim 10,
wherein the response signal consists of a PSK modulating signal.

12. The IC card processing apparatus as set forth in claim 10,
wherein the response signal consists of a modulating signal by Manchester code.
